# EUROPEAN PATENT APPLICATION

(11) **EP 2 336 785 A1**
(43) Date of publication of application: **22.06.2011**
(21) Application number: 09817924.5
(22) Date of filing: 05.10.2009
(51) Int. Cl.: G01N 35/08, G01N 37/00

(54) **ANALYTIC INSTRUMENT AND METHOD FOR MANUFACTURING SAME**

(30) Priority: 05.10.2008 JP 2008259150
(71) Applicant: Arkray, Inc., Minami-ku Kyoto-shi Kyoto 601-8045 (JP)
(72) Inventor: KITAMURA Shigeru, Kyoto-shi Kyoto 601-8045 (JP)
(74) Representative: HOFFMANN EITLE
(86) International application number: PCT/JP2009/067366
(87) International publication number: WO 2010/038897

(57) **Abstract**

An analytic instrument (1) is provided with a channel (20) for moving a sample, and a reservoir (20F) for holding the sample, and has a first member (2) and a second member (3) bonded together by means of a solvent. The analytic instrument (1) is further provided with a solvent channel (21) which is formed at least on the first member (2) or the second member (3). The first member (2) and the second member (3) are fused to each other along the solvent channel (21) or the periphery thereof. Preferably, the solvent channel (21) is formed along at least a part of the channel (20) or the reservoir (20F).

## Description

### [Field of the Invention]

The present invention relates to an analytic instrument and a method of manufacturing an analytic instrument including a channel for moving a liquid required for analyzing a sample.

### [Background Art]

As a mode of analytic instruments, there is analytic instrument including a base plate on which a channel is formed and a cover joined to the base plate so that the channel is covered. A method of joining the base plate and the cover together in this type of analytic instrument is exemplified by, e.g., a diffusion joining method (refer to, e.g., Patent document 1), a method which utilizes a solvent (refer to, e.g., Patent document 2) and a method which utilizes a bonding element.

The diffusion joining method is carried out by the following processes. To start with, modification is done in a way that lowers a glass transition temperature by irradiating energy over a joint surface of one of the base plate and the cover. Next, the cover is pressed against the base plate in a state where the base plate and the cover are aligned with each other. Subsequently, the thus-aligned base and cover are heated at a temperature set higher than the glass transition temperature in a modification area but lower than the glass transition temperatures of the base plate and of the cover. With this expedient, the modification area is selectively softened, and therefore the base plate and the cover may be joined together. According to the method such as this, neither the solvent nor the bonding element is required, and a high level of alignment accuracy may be ensured.

A problem in terms of a manufacturing cost, however, arises because of requiring the modification of the base plate and the cover, and a pressurization process and a heating process. To be specific, it is required not only an energy irradiation device capable of irradiating the base plate and the cover with vacuum ultraviolet-rays as an energy source for modifying the base plate and the cover but also a pressurization temperature control device for heating the base plate and the cover at a target temperature in a state of pressing the cover against the base plate. Therefore, the diffusion joining method causes a rise in manufacturing cost by necessity of the expensive devices. Further, the diffusion joining method has low productivity because a period of time required to join elongates by the modification process and the heating process. Besides, in the case of manufacturing the analytic instrument which retains a reagent, there is concern over deterioration of the reagent due to the irradiation of the energy and the heating.

The method of utilizing the solvent is a method that the solvent is coated over the periphery of the channel to dissolve the periphery of the channel, the base plate and the cover are aligned with each other and thus joined. This method is capable of joining the base plate and the cover together by pressing the cover against the base plate after coating the solvent, thereby enabling the base plate and the cover to be joined easily and advantageously in terms of cost.

The base plate and the cover need aligning with each other before the solvent is dried (in a state where the periphery of the channel is dissolved), and hence the alignment is required to be done in a comparatively short period of time. Further, in the analytic instrument such as the micro device, the channel is micronized, and it is therefore difficult to coat the solvent over the periphery of the channel.

The method of utilizing the bonding element is a method of joining the base plate and the cover together by interposing the bonding element such as a double-sided adhesive tape and a bonding agent in between the base plate and the cover. This method is a method of aligning and thus joining, after applying the bonding element to the base plate or the cover, the base plate and the cover together and can be therefore implemented easily and advantageously in terms of cost.

The analytic instrument manufactured by this method has, however, a possibility that the sample and reagent each moving via the channel when used might be brought into contact with the bonding element and therefore be contaminated. Further, a sectional dimension of the channel increases corresponding to a thickness of the bonding element, and hence this might hinder the micronization of the channel and cause dispersion in device dimension and, by extension, channel dimension due to dispersion in thickness dimension of the bonding element.

Patent document 1: Japanese National Publication of International Patent Application No. 2003-509251
Patent document 2: Japanese Patent No.4021391

### [Disclosure of the Invention]

### [Problems to be solved by the Invention]

The present invention aims at providing an analytic instrument enabled to be manufactured easily and advantageously in terms of cost and to align two members to be joined readily with high accuracy and having a small amount of dispersion of dimensional accuracy, and providing a technology that can be applied to the analytic instrument including the micronized channel.

### [Means for solving the Problems]

According to a first aspect of the present invention, an analytic instrument includes: at least one of a flow channel for moving a sample and a reservoir for retaining the sample; a first member and a second member which are joined together by use of a solvent; and a solvent channel formed in at least one of the first member and the second member, wherein the first member and the second member are fused together in the solvent channel or a peripheral portion thereof.

The solvent channel is formed, for example, along at least a part of the channel or the reservoir. It is preferable that the analytic instrument has, when the analytic instrument includes a reagent retaining portion retaining a reagent, a portion which surrounds the reagent retaining portion.

The solvent channel opens, for example, at a peripheral edge of at least one of the first member and the second member.

The solvent channel serves to apply, for example, a capillary force for moving the solvent.

Preferably, for example, a shape of a general cross-section of the solvent channel includes a rounded portion, at least one angular portion that is rounded as viewed in rectangular cross-section.

Herein, the general cross-section of the solvent channel according to the present invention occupies a principal portion within the channel and represents a portion taking a uniform cross-sectional shape.

A square measure of the general section of the channel is, for example, on the order of 1µm² - 100mm², and, to give one example, a channel of a so-called micro device is applied.

According to a second aspect of the present invention, a method of manufacturing an analytic instrument, includes: a first step of forming at least one of a channel for moving a sample and a reservoir for retaining the sample in at least one of a first member and a second member; a second step of joining the first member and the second member together by use of a solvent; and further a third step of forming a solvent channel for moving the solvent in at least one of the first member and the second member.

Herein, the third step may be executed separately from the first step and may also be executed simultaneously with the first step. Namely, at least one of the channel and the reservoir and the solvent channel may be separately formed and may also be formed simultaneously.

The second step includes joining the first member and the second member together in the solvent channel or a peripheral portion thereto by making the solvent exist in the solvent channel.

In the third step, the solvent channel is formed in a position along at least a part of the channel or the reservoir.

Herein, the scheme "the solvent channel is formed in the position along at least a part of the channel or the reservoir" is not limited to a case where one (the same member) of the first member and the second member is formed with the solvent channel and the channel or the reservoir. Namely, one of the first member and the second member may be formed with the solvent channel, and the other member may be formed with the channel or the reservoir.

In the first step, the solvent channel is formed as the solvent channel including, for example, a reagent retaining portion for retaining the reagent. In this case, it is preferable that the solvent channel is formed as the solvent channel including a portion which surrounds the reagent retaining portion in the third step.

The third step includes forming the solvent channel which has a discharge port serving to discharge, for example, at least any one of the solvent and a gas in the solvent channel and opening at leastwise any one of the first member and the second member. In this case, in the second step, the solvent is discharged from the discharge port.

In the second step, for example, the solvent is retained in the solvent channel by the capillary force generated in the solvent channel. In the second step, the solvent may be retained in the solvent channel by utilizing an external motive force.

In the third step, for example, a shape of a general cross-section of the solvent channel includes a rounded portion, at least one angular portion that is rounded as viewed in rectangular cross-section.

In the first step, a square measure of the general cross-section of the channel is, e.g., on the order of 1µm² - 100mm². Namely, the manufacturing method of the present invention may be applied to a case of manufacturing a so-called micro device.

### [Brief Description of the Drawings]

[FIG. 1] FIG. 1 is a whole perspective view depicting one example of an analytic instrument according to the present invention.
[FIG. 2] FIG. 2 is a disassembly perspective view of the analytic instrument illustrated in FIG. 1.
[FIG. 3] FIG. 3 is a plan view of a base plate of the analytic instrument illustrated in FIG. 1.
[FIG. 4] FIG. 4 is a cross-sectional view illustrating a cross-section taken along the line IV-IV in FIG. 3 and a principal portion thereof in enlargement.
[FIG. 5] FIG. 5A is a plan view for explaining a channel in a base plate illustrated in FIG. 3, and FIG. 5B is a plan view for explanation of a solvent channel in the base plate.
[FIG. 6] FIGS. 6A through 6C are cross-sectional views for explaining other examples of a cross-sectional shape of the solvent channel, showing the principal portion in enlargement.
[FIG. 7] FIGS. 7A and 7B are perspective views for explaining a method of joining the base plate and a cover together.
[FIG. 8] FIGS. 8A through 8C are cross-sectional views for explaining the method of joining the base plate and the cover together, showing the principal portion thereof in enlargement.
[FIG. 9] FIG. 9 is a disassembled perspective view which corresponds to FIG. 2 and illustrates another example of the analytic instrument according to the present invention.
[FIG. 10] FIG. 10 is a plan view illustrating the principal portion of the base plate of the analytic instrument illustrated in FIG. 9.
[FIG. 11] FIG. 11 is a cross-sectional view illustrating the principal portion of the base plate of the analytic instrument illustrated in FIG. 9.

### [Description of the Reference Numerals and Symbols]

- 1: analytic instrument
- 2: base plate (first member)
- 20: channel
- 20F: reagent retaining portion (reservoir)
- 21: solvent channel
- 21Ea: discharge port
- 3: cover (second member)
- 34: discharge port

### [Mode for Carrying out the Invention]

An analytic instrument and a manufacturing method thereof according to the present invention will hereinafter be described with reference to the drawings.

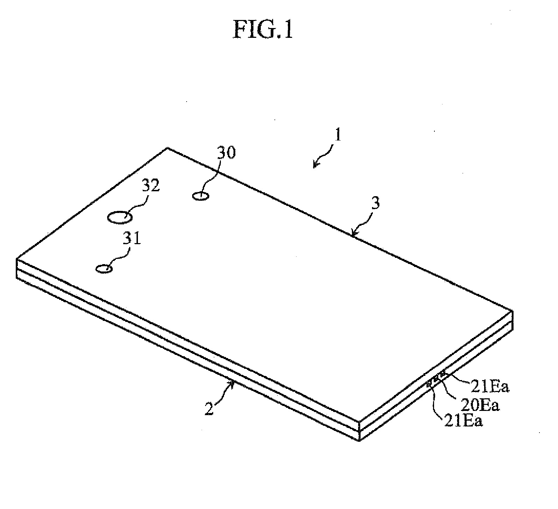

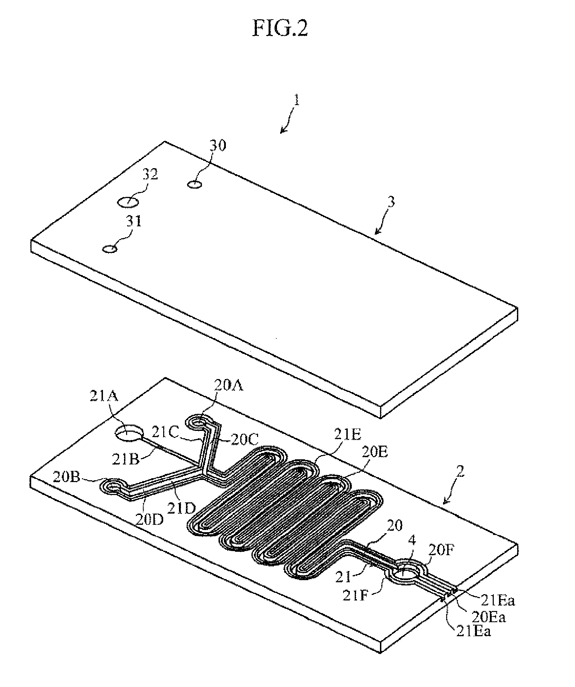

An analytic instrument 1 illustrated in FIGS. 1 and 2 is configured as a so-called micro device and is formed so as to suit an analysis of a sample by an optical technique. The analytic instrument 1 provides a reaction field, in which a base plate 2 and a cover 4 are fused directly at a portion along the periphery of a channel 21.

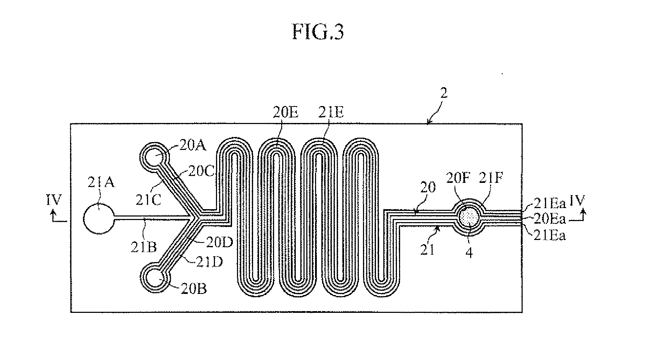

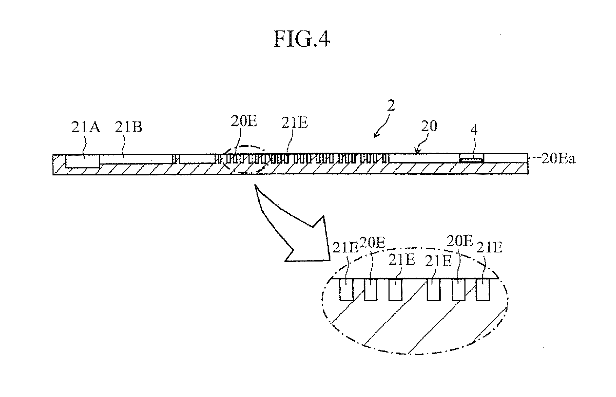

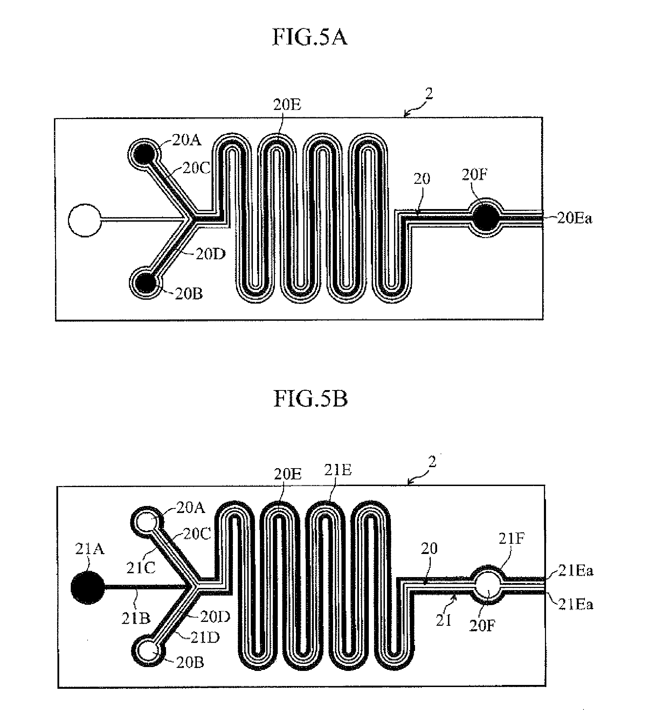

As illustrated in FIGS. 2 through 5, the base plate 2 includes a flow channel 20 (depicted in black in FIG. 5A) and a solvent channel 21(depicted in black in FIG. 5B).

The channel 20 is a portion for moving a liquid required for the analysis by capillary force. As a matter of course, the flow channel 20 may be configured so that the liquid is moved by external motive force of a pump and a like or by electrostatic force.

The flow channel 20 is formed in a uniform rectangle in cross-sectional shape at a principal portion, and a length of one side in rectangular cross-section is set to, for example, 1 µm - 1mm. As a matter of course, cross-sectional shape of the flow channel 20 may, without being limited to the rectangle, take shapes such as a polygon and a semicircle. The channel 20 has liquid receiving portions 20A, 20B, liquid introducing channels 20C, 20D, a liquid mixing channel 20E and a reagent retaining portion 20F.

The liquid receiving portions 20A, 20B are portions to which the liquid retained in the channel 20 is led in and connect to the liquid introducing channels 20C, 20D.

The liquid introducing channels 20C, 20D connect the liquid receiving portions 20A, 20B to the liquid mixing channel 20E.

The liquid mixing channel 20E is a portion to mix the liquids introduced from each of the liquid receiving portions 20A, 20B. The liquid mixing channel 20E has a meander-shape on the whole and is contrived to increase a length of the channel. A terminal end 20Ea of the liquid mixing channel 20E opens sideways of the analytic instrument 1, and the open portion functions as a discharge port (20Ea) for discharging outside a gas existing in an interior of the flow channel 20.

The reagent retaining portion 20F is formed in a terminal end area of the flow channel 20 (the liquid mixing channel 20E) and retains a reagent portion 4. The reagent retaining portion 20F configures a measuring portion irradiated with light emitted from a light source for measurement in the analytic device.

The reagent portion 4, of which a composition is determined in accordance with a component to be analyzed though, is formed in, for example, a solid state that is dissolved in a liquid. The reagent portion 4 may has a configuration in which the reagent is retained in a porous substance such as a gel and may also has a configuration in which a plurality of layers are stacked, and the present invention does not particularly limit a mode thereof. The reagent portion 4 may be omitted from the analytic instrument 1 used in a way that supplies the sample and the reagent.

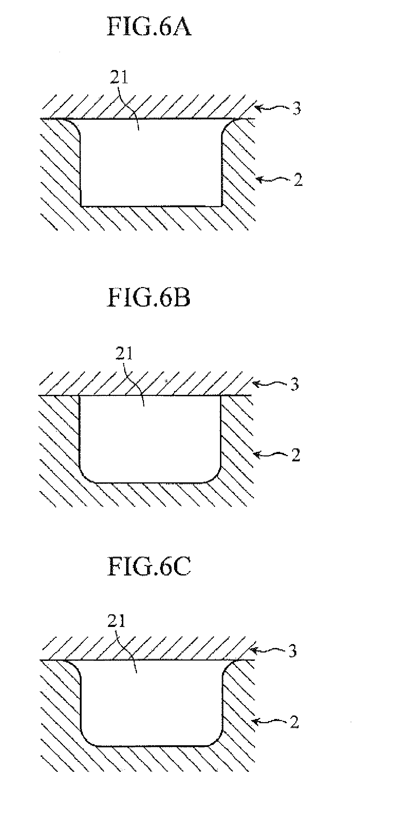

The solvent channel 21 serves to, when joining the base plate 2 and the cover 3 together by use of the solvent, move and retain the solvent. The solvent channel 21 serves to move the solvent by , for example, the capillary force. In the case of moving the solvent by the capillary force via the solvent channel 21, with respect to a dimension of the general cross-section of the solvent channel 21, if the cross-sectional shape is a rectangle , the length of one side in the rectangular section is set on the order of, for example, 1 µm - 10 mm. As a matter of course, the solvent channel 21 may, without being limited to the rectangle, take the cross-sectional shape such as the polygon or the semicircle other than the rectangle and may also take the shapes excluding the polygon and the semicircle as in the examples illustrated in FIGS. 6A - 6C. The example illustrated in FIG. 6A is that angular portions of an upper side of the rectangular cross-section are rounded, the example illustrated in FIG. 6B is that the angular portions of a lower side of the rectangular cross-section are rounded, and the example illustrated in FIG. 6C is that all of the angular portions of the rectangular cross-section are rounded. In such a case that the solvent channel 21 takes the cross-sectional shape other than the rectangle, the area of the general cross-section is set on the order of, for example, 1 µm² - 100 mm².

The solvent in the solvent channel 21 may be moved by utilizing the external motive force such as a pump and a like instead of the capillary force.

The solvent channel 21 having the function such as this is formed along the flow channel 20 (so as to surround the flow channel 20) on the whole, and includes a liquid receiving portion 21A, an introducing channel 21B, liquid receiving portion go-around portions 21C, 21D, a mixing channel side portion 21E and a reagent retaining portion go-around portion 21F.

The liquid receiving portion 21A serves to introduce the solvent and connects via the introducing channel 21B with the liquid receiving portion go-around portion 21B

The introducing channel 21B serves to introduce the solvent of the liquid receiving portion 21A to the liquid receiving portion go-around portions 21C, 21D and connects with the liquid receiving portion 21A and the liquid receiving portion go-around portions 21C, 21D.

The liquid receiving portion go-around portions 21C, 21D extend sideways of the liquid introducing channels 20C, 20D on one side, along the peripheries of the liquid receiving portions 20A, 20B and sideways of the liquid introducing channels 20C, 20D on the other side.

The mixing channel side portion 21E has continuity to the liquid receiving portion go-around portions 21C, 21D, and extends along the liquid mixing channel 20E on both sides of the mixing channel side portion 21E. The terminal end 20Ea of the mixing channel side portion 21E opens sideways of the base plate 2 and functions as the discharge port (21Ea) for discharging the solvent.

The reagent retaining portion go-around portion 21F is provided in the terminal end area of the mixing channel side portion 21E and is formed so that the reagent retaining portion go-around portion 21F surrounds the periphery of the reagent retaining portion 20F.

As illustrated in FIGS. 1 and 2, the cover 3 is stacked on the base plate 2 so as to cover the flow channel 20 and the solvent channel 21 and includes liquid introducing ports 30, 31 and a solvent introducing port 32.

The liquid introducing ports 30, 31 are formed just above the liquid receiving portions 20A, 20B of the flow channel 20 in the base plate 2.

The solvent channel introducing port 32 is formed just above the liquid receiving portion 21A of the solvent channel 21 in the solvent introducing port 32 and communicates with the liquid receiving portion 21A.

This type of analytic instrument 1 is used in a way that leads in the liquid necessary for the analysis via the liquid introducing ports 30, 31 in the cover 3. The liquids are, as understood with reference to FIG. 5A, led respectively into the liquid introducing channels 20C, 20D via the liquid receiving portions 20A, 20B by dint of, e.g., the capillarity, and reach the reagent retaining portion 20F after moving while being mixed in the liquid mixing channel 20E. With respect to the liquids mixed in the liquid mixing channel 20E, the reagent portion 4 (see FIGS. 2 through 4) is dissolved in the reagent retaining portion 20F, whereby the sample and the reagent react on each other. Reaction products between the sample and the regent are analyzed by the analyzing device as described above.

On the other hand, if the analytic instrument 1 is configured to omit the reagent portion 4 of the reagent retaining portion 20F, the reagent and the sample are introduced into the liquid receiving portions 20A, 20B. The reagent and the sample move while reacting on each other in the liquid mixing channel 20E and thus reach the reagent retaining portion 20F.

Next, a method of manufacturing the analytic instrument 1 will be described. The following discussion will be, however, made by exemplifying a case of individually manufacturing the analytic instruments 1 on a one-by-one basis.

The analytic instrument 1 is manufactured through a cover forming process, a base plate forming process and a joining process.

The cover forming process is executed, for example, by cutting, after stamping out a transparent plastic film, the stamped-out plastic film to a target size. As comprehended with reference to FIGS. 1 and 2, the stamp-out involves forming through-holes that are to become the liquid introducing ports 30, 31 and the solvent introducing port 32. Of course, the cover 3 may be formed by executing the stamp-out after cutting the plastic film. One surface of the cover 3 (which is the surface covering the flow channel 20 of the base plate 2) may undergo a hydrophilic process by irradiating this one surface with ultraviolet-rays or coating a surface active agent over this surface.

Materials (for forming the cover 3) for forming the plastic film may be exemplified by high polymer materials such as polydimethylsiloxane (PDMS), polydimethyl methacrylate (PMMA), polystyrene (PS), polycarbonate (PC), polyethylene terephthalate (PET) or cyclic olefin (e.g., a copolymer of ethylene and a dicyclopentadien group compound, or a copolymer of ethylene and a norbornene group compound). The plastic film (cover 3) may be also formed of a combination of two or more types of high polymer materials. For example, the plastic film (cover 3) may be molded by use of a material obtained by two or more types of exemplified high polymer materials and may also be attained by pasting the films or sheets formed by the different high polymer materials.

The base plate forming process is executed, for example, by injection molding which involves using a thermoplastic resin. In the injection molding, contrivance of a shape of a metal mold enables the flow channel 20 (depicted in black in FIG. 5A) and the solvent channel 21 (depicted in black in FIG. 5B) to be formed in the base plate 2. The flow channel 20 and the solvent channel 21 may be also formed by executing an etching process, laser machining, or a machine work.

The materials of the base plate may be exemplified by the high polymer materials such as polydimethyl methacrylate (PMMA), polystyrene (PS), polycarbonate (PC), polyethylene terephthalate (PET) or cyclic olefin (e.g., the copolymer of ethylene and the dicyclopentadien group compound, or the copolymer of ethylene and the norbornene group compound).

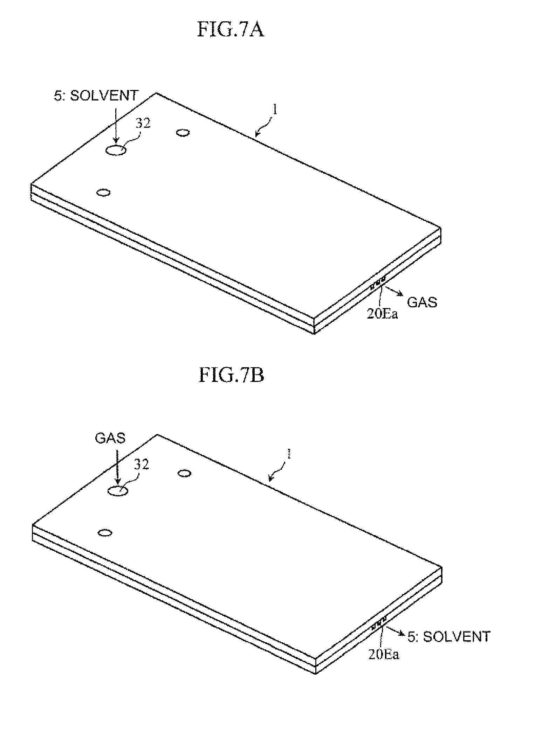

A joining process is, as shown in FIGS. 7A and 7B, executed by, after filling, in a state where the cover 3 is aligned with the base plate 2 and is thus pressed against the base plate 2, the solvent channel 21 with a solvent while discharging the gas of the solvent channel 21 via the solvent introducing port 32 and the liquid receiving portion 21A of the solvent channel 21, discharging the solvent from the solvent channel 21.

As illustrated in FIG. 7A, the solvent channel 21 is filled with the solvent by the capillary force generated in the solvent channel 21 or the external motive force of the pump etc.

The solvent for use is, it is enough, a solvent capable of dissolving the surfaces of the base plate 2 and the cover 3 and permeating between the base plate 2 and the cover 3 from the solvent channel, and may be determined depending on the materials of the base plate 2 and the cover 3. The solvent may involve using organic solvents such as alkanes, alcohols, polyvalent alcohols, aromatic hydrocarbon, hydrocarbon halide, ethers, ketones, esters, or amides.

The organic solvent of alkanes may be exemplified such as straight-chain alkanes (n-hexane, n-pentane and n-hepta).

The organic solvent of alcohols may be exemplified such as methanol, ethanol, n-propanol, isopropanol, butanol and octanol.

The organic solvent of multivalent alcohols may be exemplified such as methyl cellosolve and butyl cellosolve.

The organic solvent of aromatic hydrocarbons may be exemplified such as benzene, toluene and xylene.

The organic solvent of hydrocarbon halides may be exemplified such as methylene chloride, ethylene chloride, dichloromethane, 1,2-dichloroethane, chloroform, trichloroethane and tetrachloroethane.

The organic solvent of ethers can be exemplified such as diethyl ether, tetrahydrofuran, dioxane and, in addition acetal.

The organic solvent of ketones can be exemplified such as alkyl ketone (e.g., acetone, methyl ethyl ketone), methyl isobutyl ketone and cyclohexane.

The organic solvent of esters can be exemplified such as acetate ester (acetate methyl, acetate ethyl, etc).

The organic solvent of amides can be exemplified such as dimethylformamide.

The single type of solvent or a mixture of plural types of solvents may be used. For example, cyclic olefin (copolymer of ethylene and dicyclopentadien group compound, or copolymer of ethylene and norbornene group compound) or polycarbonate is employed as the material of the base plate 2 and the cover 3, in which case there may be used one type of organic solvent selected from or a combination of plural types of xylene, trichloroethane, dioxane, methyl ethyl ketone, methyl isobutyl ketone, cyclohexane and acetate ethyl.

The solvent may be supplied as the necessity may arise in a state of being mixed with an additive. A usable additive is an additive serving to adj ust a moving velocity of the solvent in the solvent channel 21 or adjust a dissolving velocity of the base plate 2 and the cover 3 or adjust a solvent viscosity and surface force in terms of another aspect. The additive can be exemplified such as ethanol, acetate, xylene or dioxane. A usage quantity of the additive is on the order of, e.g., 5 - 10 wt% of a total quantity of the solvent.

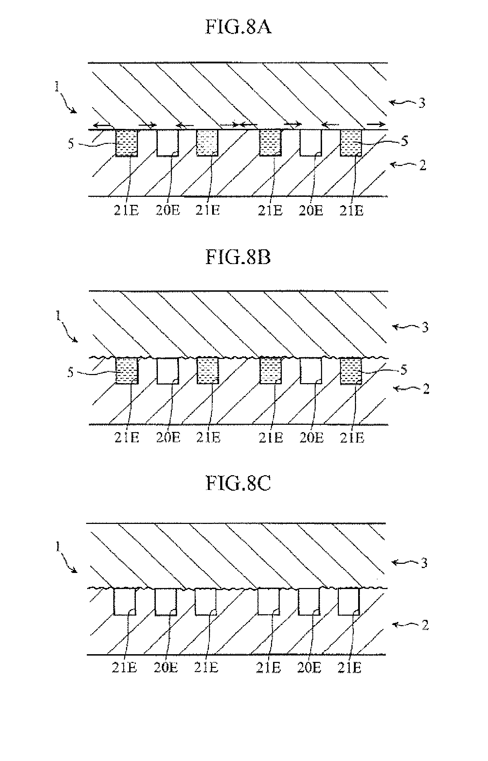

As shown in FIG. 8A, if the solvent 5 exists in the solvent channel 21, the solvent 5 permeates, by the capillary force, the minute gaps between the base plate 2 and the cover 3 (see the arrowheads in FIG. 8A). The permeation of the solvent 5 is based on the capillary force, and hence the solvent 5 in the solvent channel 21 does not permeate up to the flow channel 20. As a result, as illustrated in FIG. 8B, the portion (between the solvent port 21 and the flow channel 20) peripheral to the solvent channel 21 is selectively dissolved (see a wavy line in FIG. 8B) at the area where the base plate 2 the cover 3 are brought into contact with each other.

At this time, as shown in FIGS. 6A and 6C, if the shape of the general section of the solvent channel 21 is set to the shape in which the angular portions vicinal to the cover 3 are rounded, this configuration facilitates the permeation of the solvent into between the base plate 2 and the cover 3 from the solvent channel 21.

The permeation velocity of the solvent 5 into between the base plate 2 and the cover 3 from the solvent channel 21 may be adjusted based on the type of the additive added to the solvent 5 or a magnitude of the pressing force of the cover 3 against the base plate 2.

On the other hand, as shown in FIG. 7B, the solvent 5 is discharged from the solvent channel 21 by the external motive force of the pump etc. To be more specific, the solvent 5 is discharged from a discharge port 21Ea by pushing the air from the solvent introducing port 32 or discharged while taking in the solvent from the solvent introducing port 32 in a way that applies a suction force to the discharge port 21Ea.

As illustrated in FIG. 8C, the solvent 5 is discharged from the solvent channel 21, thereby stopping dissolving the base plate 2 or the cover 3 and solidifying the dissolved portion (indicated by the wavy line in FIG. 8C). With this contrivance, the base plate 2 and the cover 3 are directly fused together at the area (peripheral to the solvent channel 21) where the base plate 2 or the cover 3 is dissolved. The solvent channel 21 is formed along the flow channel 20 (so as to surround the flow channel 20) on the whole. Therefore, the base plate 2 and the cover 3 are directly fused together at the area along the periphery of the flow channel 20.

The method of thus joining the base plate 2 and the cover 3 together entails neither modifying the base plate 2 and the cover 3 nor a heating process. Hence, this method is advantageous in terms of a manufacturing cost because of no necessity for a device for modifying or heating the base plate 2 and the cover 3, and eliminates a necessity for concern over deterioration of the reagent portion 4 when joining the base plate 2 and the cover to each other.

At this time, as illustrated in FIGS. 6A through 6C, if the general cross-section of the solvent channel 21 takes the shape including the rounded portions, a channel resistance in the solvent channel 21 may be reduced. It is therefore feasible to quickly discharge the solvent 5 from the solvent channel 21 and to reduce a possibility that the solvent might remain in the solvent channel 21.

Further, even when adopting the mode in which the discharge port 21Ea of the solvent channel 21 opens sideways, the channel resistance in the solvent channel 21 may be reduced, and hence the solvent 5 can be quickly discharged out of the solvent channel 21.

The junction between the base plate 2 and the cover 3 involves supplying the solvent to the solvent channel 21 after aligning the base plate 2 and the cover 3 with each other, thereby eliminating the necessity for aligning the base plate 2 and the cover 3 with each other before the solvent gets dried and enabling the alignment to be surely done with an allowance in time. Moreover, in the analytic instrument 1 such as the micro device, the solvent channel 21 enables the solvent to exist in the periphery of the flow channel 20 easily and surely.

Furthermore, since the joining between the base plate 2 and the cover 3 does not involve using a bonding element like a double-sided adhesive tape and a bonding agent, such an anxiety does not exist that the sample and the reagent might be contaminated with the bonding element, and such a possibility is decreased that a dispersion might occur in sectional dimension of the flow channel 20.

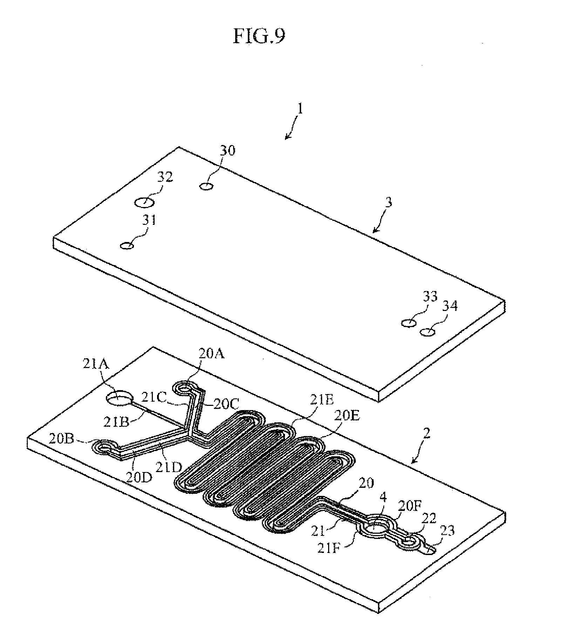

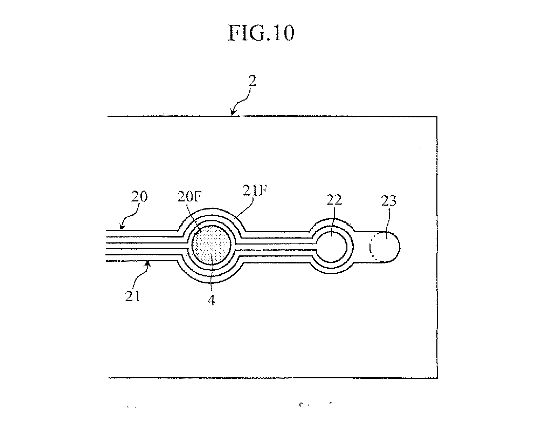

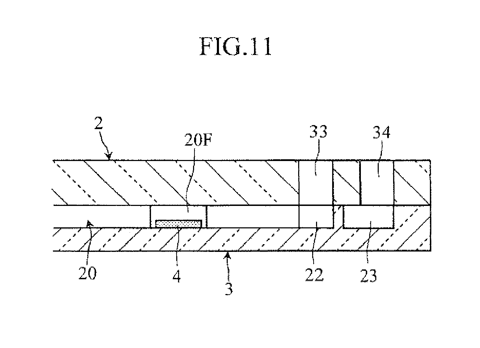

Next, another example of the analytic instrument according to the present invention will hereinafter be described with reference to FIGS. 9 through 11. In these drawings throughout, the same components as those of the analytic instrument 2, which has previously been described with reference to FIGS. 1 through 7, are marked with the same reference numerals and symbols, and the iterative explanations thereof are omitted in the following discussion.

The analytic instrument 6 illustrated in FIGS. 9 through 11 is different from the preceding analytic instrument 2 (see FIGS. 1 through 7) in terms of a configuration of the edge portions of the flow channel 20 and the solvent channel 21.

The flow channel 20 has an edge portion 22 formed just anterior to the peripheral edge of the base plate 2 but does not, unlike the preceding analytic instrument 2, open sideways at the peripheral edge of the base plate 2. The edge portion 22 is a portion for discharging the gas in the flow channel 20 when introducing the sample into the flow channel 20, and communicates with the discharge port 33 of the cover 3.

In the solvent channel 21, the edge portion 23 is, in the same way as in the case of the flow channel 20, formed just anterior to the peripheral edge of the base plate 2 but does not, unlike the preceding analytic instrument 2, open sideways at the peripheral edge of the base plate 2. The edge portion 23 is a portion for discharging the gas in the solvent channel 21 when introducing the solvent into the solvent channel 21 and discharging the solvent remaining in the solvent channel 21, and communicates with the discharge port 34 of the cover 3.

As a matter of course, the present invention is not limited to the embodiment discussed above, and the design can be changed in a variety of forms.

The present invention can be applied to an analytic instrument in which three or more types of liquids are mixed, an analytic instrument in which a plurality of channels is formed to enable a plurality of reaction systems to be configured, or an analytic instrument configured to supply the sample directly to a reservoir such as a reaction reservoir without any existence of the channel. The present invention can be, by its very nature, applied to an analytic instrument configured to analyze the sample by an electrochemical technique without being limited to the analytic instrument configured to analyze the sample by the optical technique.

The present invention can be applied to a case of simultaneously manufacturing the plurality of analytic instruments. For example, after plastic-molding a plate member, which should become the base plate, formed with the plurality of elements and joining the cover to this plate member, the plurality of analytic instruments may be simultaneously manufactured by cutting this cover-joined plate member.

The present invention can be further applied, without being limited to the case of joining the two plate members, to a case of joining three or more plate members.

## Claims

1. An analytic instrument comprising:
at least one of a flow channel for moving a sample and a reservoir for retaining the sample;
a first member and a second member which are joined together by use of a solvent; and
a solvent channel formed in at least one of the first member and the second member, wherein the first member and the second member are fused together in the solvent channel or a peripheral portion thereof.

2. The analytic instrument according to claim 1, wherein the solvent channel is formed along at least a part of the flow channel or the reservoir.

3. The analytic instrument according to claim 1, wherein the solvent channel has a discharge port for discharging at least one of a solvent in the solvent channel and a gas therein, and
the discharge port opens in at least one of the first member and the second member.

4. A method of manufacturing an analytic instrument, comprising:
a first step of forming at least one of a flow channel for moving a sample and a reservoir for retaining the sample in at least one of a first member and a second member;
a second step of joining the first member and the second member together by use of a solvent; and
a third step of forming a solvent channel for moving the solvent in at least one of the first member and the second member.

5. The method of manufacturing an analytic instrument according to claim 4, wherein the first member and the second member are joined in the solvent channel or a peripheral portion thereof by making the solvent exist in the solvent channel in the second step.

6. The method of manufacturing an analytic instrument according to claim 4, further comprising a fourth step, executed after the third step but before the second step, of aligning the first member and the second member.

7. The method of manufacturing an analytic instrument according to claim 4, wherein the solvent channel is formed in a position along the part of the flow channel or the reservoir in the third step.

8. The method of manufacturing an analytic instrument according to claim 4, wherein the solvent channel for discharging at least one of a solvent in the solvent channel and a gas therein and having a discharge port opening in at least one of the first member and the second member is formed in the third step, and
the at least one of the solvent and the gas is discharged from the discharge port in the second step.
